(19) Europäisches Patentamt
European Patent Office
Office européen des brevets

(11) EP 0 507 525 B1

(12) **EUROPEAN PATENT SPECIFICATION**

(45) Date of publication and mention
of the grant of the patent:
**11.06.1997 Bulletin 1997/24**

(51) Int Cl.6: **H03D 7/14**, H03C 5/00

(21) Application number: **92302764.3**

(22) Date of filing: **30.03.1992**

(54) **Radio frequency modulators**

Modulatoren für hochfrequente Signale

Modulateurs pour signaux radio-fréquence

(84) Designated Contracting States:
**DE FR GB NL**

(30) Priority: **03.04.1991 JP 99459/91**
**03.04.1991 JP 99460/91**

(43) Date of publication of application:
**07.10.1992 Bulletin 1992/41**

(73) Proprietors:
• **SONY CORPORATION**
**Tokyo 141 (JP)**
• **ALPS ELECTRIC CO., LTD.**
**Ota-ku Tokyo 145 (JP)**

(72) Inventors:
• **Ishikawa, Nobuyuki, c/o Patents Division**
**Shinagawa-ku, Tokyo 141 (JP)**
• **Nishimori, Eiji, c/o Alps Electric Co. Ltd.**
**Ota-ku, Tokyo (JP)**

(74) Representative: **Cotter, Ivan John et al**
**D. YOUNG & CO.**
**21 New Fetter Lane**
**London EC4A 1DA (GB)**

(56) References cited:
**EP-A- 0 107 295          EP-A- 0 154 318**

• **PATENT ABSTRACTS OF JAPAN vol. 7, no. 200
(E-196)3 September 1983 & JP-A-58 097 975**

## Description

This invention relates to radio frequency modulators.

Various television signals are now in commercial use through the world. For example, a PAL television signal is employed in European countries except France, a SECAM television signal is employed in France, and an NTSC television signal is employed in Japan and U.S.A.

A video tape recorder (VTR) for use in France is provided with a radio frequency (RF) modulator using the positive modulation system which is the SECAM modulation system, and a VTR for use in other countries is provided with an RF modulator using the negative modulation system. Thus, the respective VTRs are able to generate television signals conforming to their own television systems and the television signals thus generated can be received and reproduced by television receivers of respective systems.

In this way, television signals of different television systems are generated in respective countries. In countries near to France, television receivers of so-called dual type capable of receiving both PAL and SECAM television signals are commonly utilized.

To meet this requirement, VTRs having RF modulators of a switching type for switching PAL and SECAM television signals for processing are commercially available in those countries.

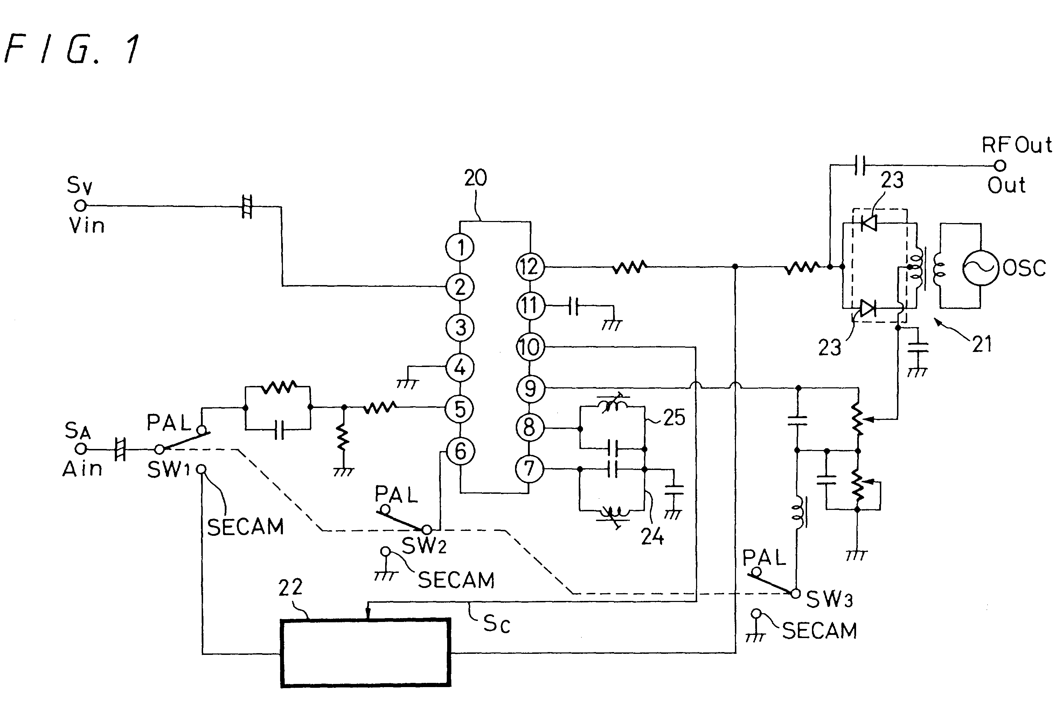

Figure 1 shows a circuit configuration of previously proposed PAL/SECAM switching type RF modulator comprising an integrated circuit (IC) 20 forming a frequency (FM) modulator to which various circuits and switches SW1 to SW3 are connected as external circuit elements. Of the three switches SW1 to SW3, the switch SW1 switches an audio signal $S_A$ applied to an audio input terminal Ain in response to operational modes of the VTR, such as when the VTR is operated in the PAL mode or in the SECAM mode. The switch SW1 is externally coupled to the IC 20 for the reason given below.

More specifically, the IC 20 is provided with only one FM modulator. Thus, when the FM modulator is operated in the SECAM mode, it is operated as an AM carrier generator. Consequently, when the FM modulator is operated in the SECAM mode, the audio signal $S_A$ should be completely prevented from being supplied to the IC 20. To realize this perfectly, the switch SW1 is provided to switch the circuits to which the input audio signal is supplied.

With the RF modulator so arranged, when the switch SW1 is switched to the SECAM side contact, a carrier signal Sc of 6.5 MHz from a terminal (10) of the IC 20 is supplied to an audio amplitude (AM) modulator 22 which then generates a SECAM audio RF signal. This audio RF signal is modulated by a video signal which is supplied to the IC 20 through a video signal which is supplied to the IC 20 through a video input terminal Vin, and is thereby added to a video signal from a terminal (12) of the IC 20. Then, the added signal is supplied through an output terminal OUT as an output signal RFout of the RF modulator.

The switch SW2 is coupled to a terminal (6) of the IC 20. When the switch SW2 is changed in position to PAL and SECAM contacts, intercarrier generating resonance circuits 24 and 25 respectively connected to terminals (7) and (8) of the IC 20 are switched in response to the PAL mode and the SECAM mode. On the other hand, the switch SW3 is provided in order to switch a dc bias of an RF modulator 21 formed of two Schottky diodes 23.

The radio frequency modulator shown in Figure 1 needs a lot of external assembly parts (about thirteen external parts) each of which is constructed in discrete form. The reason for this is that operation of the FM modulator 21 must be fine adjusted because the PAL and SECAM modes are different in modulation degree, which makes it difficult to build the RF modulator 21 into the IC 20.

Since the characteristics that the RF modulator 21 is required to have are strictly determined as described above, a circuit which varies the modulation characteristic of the audio modulator must be provided, which hinders incorporation of the audio modulator into the IC 20. Accordingly, the switch SW2 is indispensable for this RF modulator. As a consequence, in order to effect the mode switching for audio input, mixer operation point, audio oscillation switching or the like, expensive switches such as a 3-circuit 2-contact switch is needed.

Further, since the degree of modulation is adjusted by controlling an idling current of the Schottky diodes 23, a modulation degree of the video signal fluctuates considerably, which necessitates troublesome adjustment. Furthermore, the switch SW3 must be carefully shielded to prevent leakage of an intermediate frequency (IF) signal.

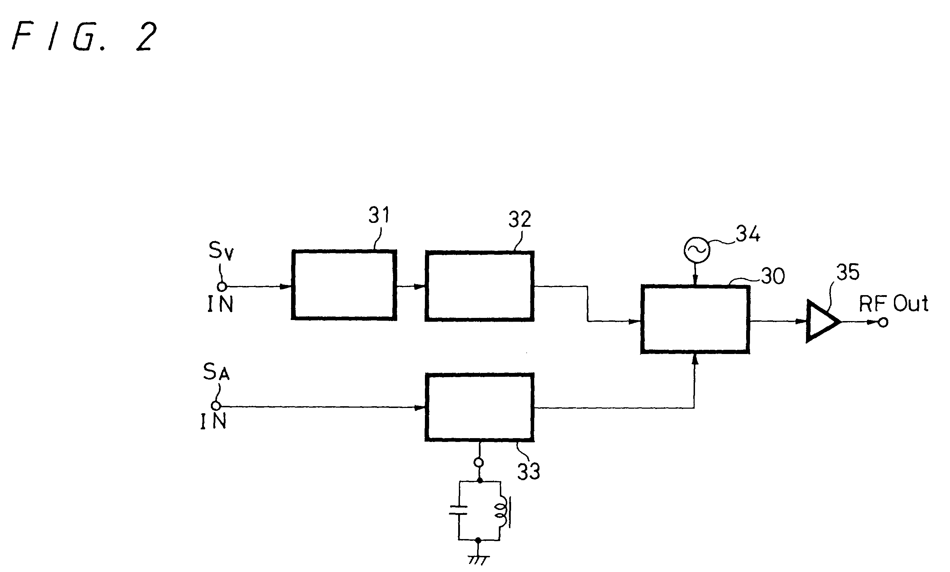

A specific example of a previously proposed RF modulator fabricated as an IC will now be described with reference to Figure 2.

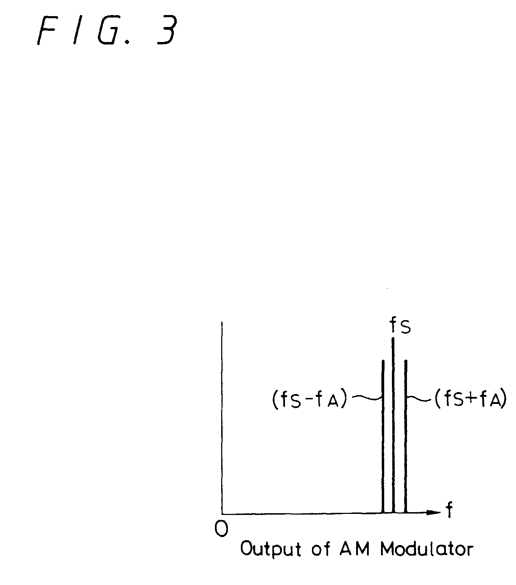

As shown in Figure 2, a video signal $S_V$ applied to a video input terminal IN is supplied through a clamping circuit 31 and a white clipping circuit 32 to a mixer circuit 30. An audio signal $S_A$ applied to an audio input terminal IN is supplied to and amplitude-modulated by an audio AM modulator 33, whereby an output shown in a spectral distribution diagram of Figure 3 is generated from the AM modulator 33. This output signal is supplied to the mixer circuit 30.

A high frequency signal is supplied from an RF carrier generating source 34 to the mixer circuit 30, in which it is mixed with the video signal $S_V$ and the audio signal $S_A$, whereby a high frequency signal RF having the same format as that of the television signal is generated. This high frequency signal RF is supplied through an amplifier 35 to an output terminal OUT.

Since the RF output is generated as described above, the RF modulator has the disadvantage that intermodulation distortions occur in the video signal $S_V$ and in the audio signal $S_A$.

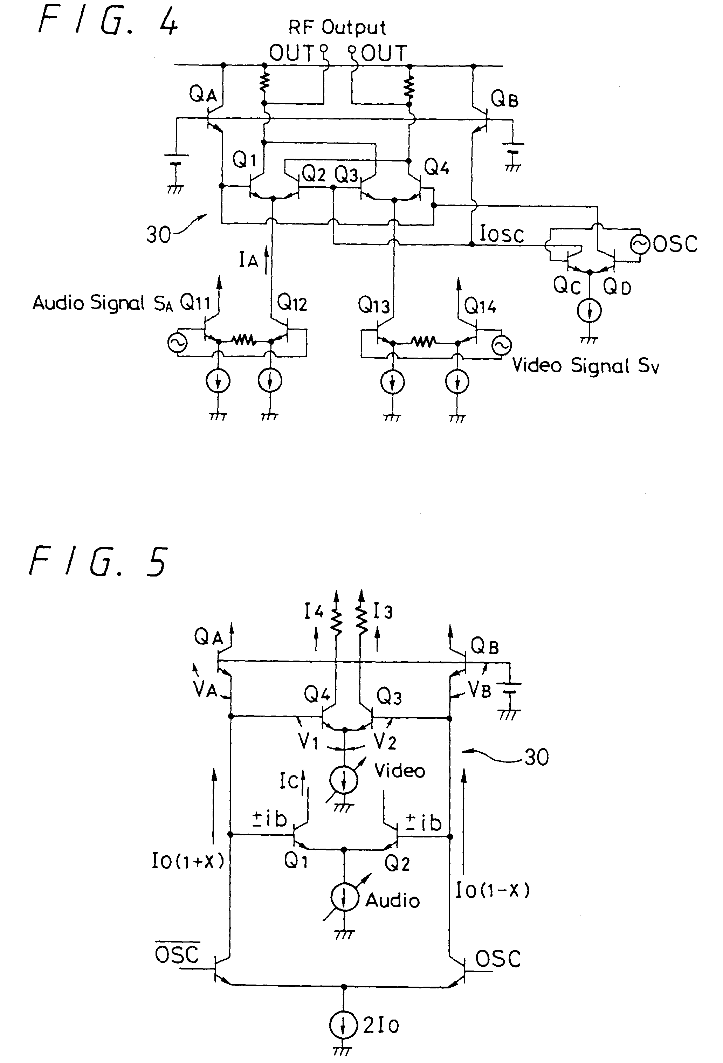

Figure 4 is a diagram showing an example of a circuit configuration of a previously proposed RF modulator fabricated as an IC. Figure 5 is a diagram used to explain operation of a main portion of the circuit of Figure 4.

As shown in Figure 4, in this RF modulator, a double balance mixer circuit 30 comprises a differential circuit formed of transistors Q1, Q2, and a differential circuit formed of transistors Q3, Q4.

The audio signal $S_A$ is supplied to a differential circuit formed of transistors Q11, Q12, and the video signal $S_A$ is supplied to a differential circuit formed of the transistors Q13, Q14. An output of a local oscillator OSC is supplied to the bases of transistors QC, QD forming a mixer driver, and is also supplied to the bases of transistors Q1 to Q4 forming the double balance mixer circuit 30.

With this circuit configuration, when a collector current $I_A$ of the transistor Q12 is changed by the audio signal $S_A$, then a modulation signal $I_A/h_{PE}$ is added to a current $I_{OSC}$ flowing through the emitters of the transistors QA, QB. Such modulation signal component is not desirable, because it acts as an intermodulation distortion which causes a sound beat interference to occur on the picture screen of the television receiver.

The above-mentioned intermodulation distortion will be described more fully with reference to Figure 5.

A base-emitter voltage $V_{BE}$ of the transistor is given by:

$$V_{BE} = kT/q \cdot 1n \cdot Ic/Is \tag{1}$$

A voltage, which results from adding a base-emitted voltage $V_A$ of the transistor QA and a base-emitter voltage $V_1$ of the transistor Q1 and a voltage, which results from adding a base-emitter voltage $V_B$ of the transistor QB and a base-emitter voltage $V_2$ of the transistor Q2 are expressed as:

$$V_A + V_1 = V_B + V_2 \tag{2}$$

Thus, from equations (1) and (2), we have:

$$kT \cdot \ln\left(\frac{I_0 \ (1+x) \pm i_b}{I_S}\right) + kT \cdot \ln\left(\frac{I_4}{I_S}\right)$$

$$= kT \cdot \ln\left(\frac{I_0 \ (1-x) \pm i_b}{I_S}\right) + kT \cdot \ln\left(\frac{I_3}{I_S}\right)$$

$$I_4 = I_3 \cdot \left(\frac{I_0(1-x) \pm i_b}{I_0(1+x) \pm i_b}\right)$$

$$= I_3 \cdot \left(\frac{I_0(1+x) \pm i_b - 2I_0x}{I_0(1+x) \pm i_b}\right)$$

$$= I_3 \cdot \left(1 - \frac{2I_0x}{I_0(1+x) \pm i_b}\right)$$

$$= I_3 \cdot \left(1 - \frac{2}{\dfrac{1}{x} + 1 \pm \dfrac{i_b}{I_0x}}\right) \qquad \cdots (3)$$

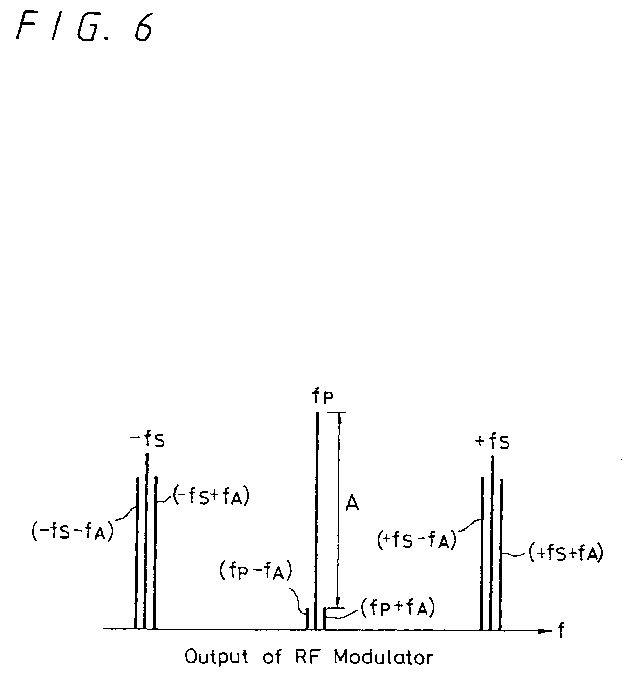

As is clear from equation (3), even when the video signal $S_V$ is not supplied, the component $i_b$ changed by the audio signal $S_A$ is produced in the output currents $I_3$ and $I_4$ as modulated outputs, resulting in an intermodulation distortion as shown in Figure 6 being produced. A level $i_b$ of this interference signal is represented as $i_b = I_C/h_{PE}$, that is, about 43 dB. In Figures 3 and 6, $f_P$ represents the frequency at which the video signal is modulated, $f_S$ the frequency at which the audio signal is modulated and $f_A$ the video signal, respectively. A reference letter A in Figure 6 is employed as an index by which the sound beat caused by the intermodulation distortion component is detected, and is expressed by a relative ratio of the maximum value of the carrier relative to the interference component. Since the intermodulation distortion is increased and the above-mentioned ratio A is reduced, the sound beat on the picture screen becomes conspicuous. Therefore, A is preferably 65 dB or more.

Previously proposed modulator arrangements are disclosed in EP-A-0 154 318, EP-A-0 107 295 and JP-A-58 097 975. In particular, EP-A-0 154 318 discloses an RF modulator circuit having a double balance type mixer whose operating characteristics are switchable between a PAL operating mode and a SECAM operating mode.

According to the present invention there is provided an RF modulator comprising:

a SECAM double balance type mixer for generating a SECAM RF output signal by modulating a high frequency signal supplied thereto from an RF carrier generating source with a predetermined signal;

a PAL double balance type mixer for generating a PAL RF output signal by modulating a high frequency signal supplied thereto from the RF carrier generating source with a predetermined signal;

a SECAM audio modulator for amplitude-modulating a SECAM audio signal supplied thereto and supplying an amplitude-modulated SECAM audio signal to said SECAM double balance type mixer;

a PAL audio modulator for frequency-modulating a PAL audio signal supplied thereto and supplying a frequency-modulated PAL audio signal to said PAL mixer;

an adding amplifier for mixing the RF output signals of the SECAM mixer and the PAL mixer; and

a PAL/SECAM switching circuit for controlling operational states of respective circuits in response to a mode switching signal supplied thereto, so that an audio signal is amplitude-modulated and a video signal is positively modulated in the SECAM mode, while the audio signal is frequency-modulated and the video signal is negatively modulated in the PAL mode.

An embodiment of the present invention can provide an RF modulator which can be made compact in size, and is free from adjustment. Such a modulator can have an improved intermodulation distortion characteristic, and prevent a sound beat from being produced on a picture screen due to an intermodulation distortion.

The invention will now be described by way of example with reference to the accompanying drawings, throughout which like parts are referred to by like references, and in which:

Figures 1, 2 and 4 show previously proposed RF modulators;

Figure 3 is a diagram cf a spectral distribution;

Figure 5 is a diagram used to explain operation of the RF modulator of Figure 4;

Figure 6 is a diagram of a spectral distribution;

Figure 7 is a block diagram showing an embodiment of RF modulator according to the present invention;

Figure 8 is a circuit diagram showing a specific example of the RF modulator of Figure 7;

Figure 9 is a waveform diagram used to explain operational differences between the PAL mode and the SECAM mode; and

Figure 10 is a schematic block diagram for explaining a PAL/SECAM switching system.

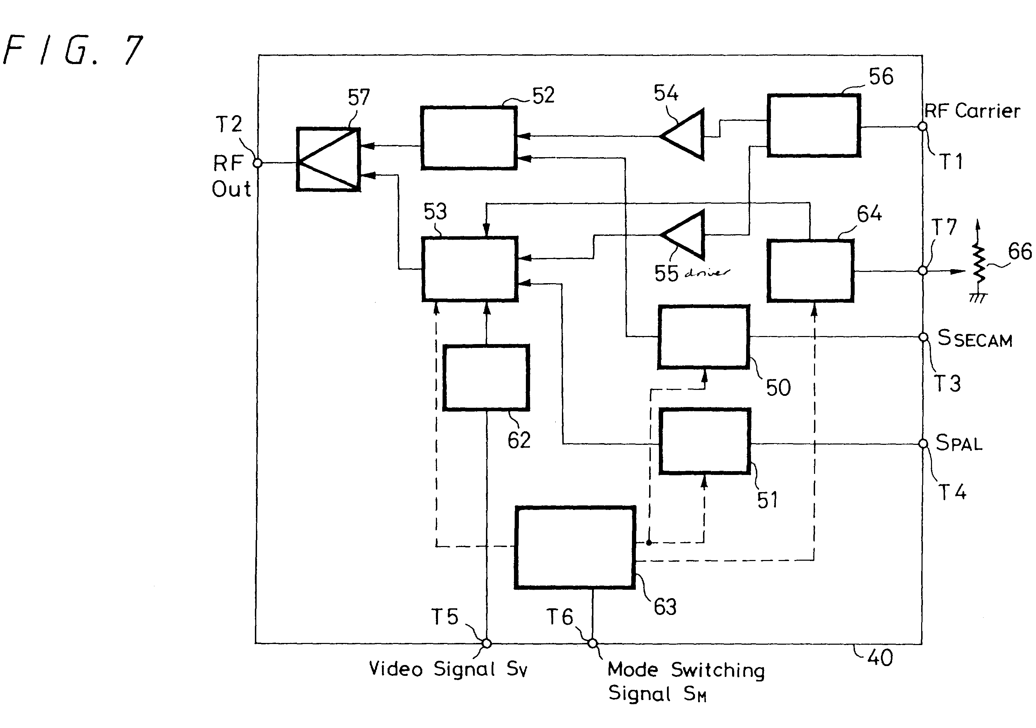

Referring to Figure 7, an embodiment of RF modulator fabricated as an IC will be described.

In Figure 7, it will be seen that all the circuit elements forming the RF modulator of this embodiment are provided within an IC 40. The RF modulator includes a SECAM mixer circuit 52 and a PAL mixer circuit 53, and a SECAM audio signal $S_{SECAM}$ and a PAL audio signal $S_{PAL}$ applied to terminals $T_3$, $T_4$ are respective supplied through an AM modulator 50 and an FM modulator 51 to the mixer circuits 52 and 53.

A first mixer driver 54 drives the SECAM mixer circuit 52, and a second mixer driver 55 drives the PAL mixer circuit 53, the mixer circuits 52, 53 being independently driven by the mixer drivers 54, 55. Carrier high frequency outputs are respectively supplied to the mixer drivers 54, 55 from an OSC buffer amplifier 56. That is, an RF carrier applied to a terminal T1 is supplied to the buffer amplifier 56, in which it is separated into carriers of two systems and then supplied to the first and second mixer driver 54, 55, respectively.

A video signal $S_V$ supplied through a terminal T5 to the IC 40 is supplied through a video clamping circuit 62 to the PAL mixer circuit 53. A mode switching signal $S_M$ supplied to the terminal T6 is supplied to a change-over switch 63 that is used to switch the PAL and SECAM modes.

The mode change-over switch 63 responds to the mode switching signal $S_M$ supplied thereto to control operation of the AM modulator 50 and the FM modulator 51, and also to control operation of the PAL mixer circuit 53. Since the modulation degree of a video signal is different in the PAL mode and in the SECAM mode, operation of a video modulation degree fine adjusting circuit 64 is controlled so as to avoid the disadvantages which may occur when the operational mode is switched. The adjusting circuit 64 is coupled through a terminal T7 to a variable resistor 66, and the video modulation degree can be controlled with high accuracy by adjusting the variable resistor 66.

In this RF modulator, the AM modulator 50 and the FM modulator 51 are provided independently, and are provided with respective independent oscillators. In addition, since the required characteristics of the mixer are eased as described later, the operational characteristics of the modulators 50, 51 need not be fine adjusted. As a consequence, all circuit elements of the modulators 50, 51 can be fabricated in the IC 40, so that the operation of the PAL and SECAM systems can be switched by a simple change-over switch fabricated in the IC 40. Therefore, an expensive switch need not be coupled to the IC 40 externally.

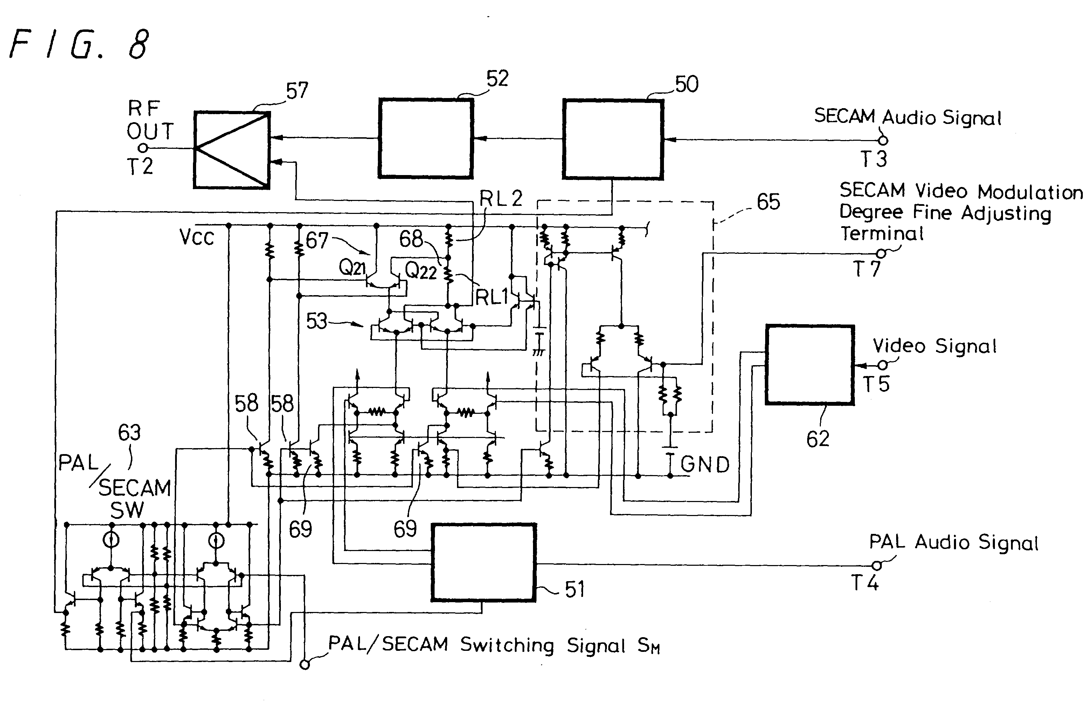

Figure 8 is a diagram showing a circuit configuration of the RF modulator of Figure 7 in the form of an IC. Specific arrangements of the respective circuits will be described below with reference to the circuit configuration of Figure 8 in which only the circuits of the PAL signal system are illustrated in the form of a discrete circuit. The circuits of the SECAM signal system are constructed similarly.

As shown in Figure 8, in this RF modulator, the SECAM mixer circuit 52 and the PAL mixer circuit 53 are each formed as a double balance type mixer. A switching circuit 67 is provided in order to switch the flow of an output current of the double balance type mixer 53, and a voltage generating circuit 68, formed of resistors RL1, RL2 connected in series, is provided to generate a voltage of a value corresponding to the flow of the output current of the double balance type mixer circuit 53. This voltage generating circuit 68 corrects an RF output level by adjusting the value of the voltage generated by the circuit 68 in response to the PAL system and the SECAM system, whereby an output of substantially the same level is obtained regardless of the PAL system/SECAM system.

The switching circuit 63 for switching operation of the audio AM/audio FM modulators 50, 51 is formed of two differential circuits as shown in Figure 8, and the modulators 50 and 51 are selectively operated by the output of one of the differential circuits, thereby to carry out the mode switching operation.

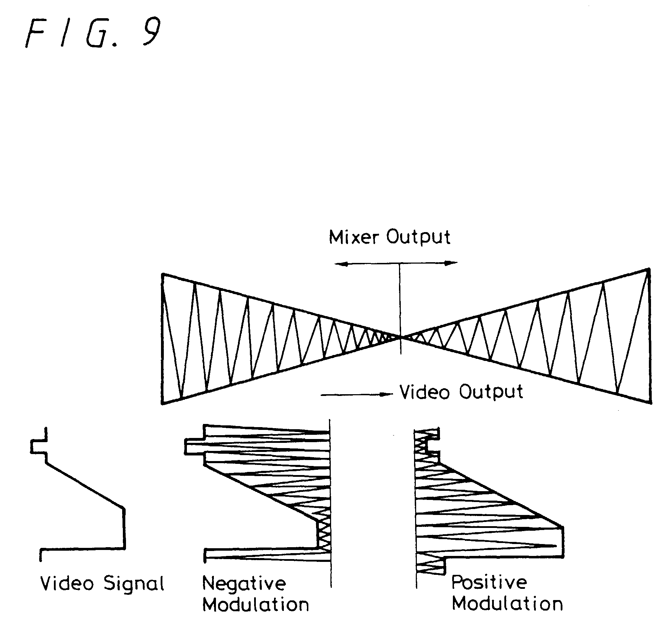

Similarly, by turning on and off transistors forming a current source 69 by an output of the other differential circuit, mode switching is carried out, in which, as shown in an operation waveform diagram of Figure 9, the modulation polarity of an input video signal is switched to a positive modulation or to a negative modulation. Then, only when the RF modulator is operated in the SECAM mode, a current source 65 for fine adjusting a mixer current is operated so as to adjust the positive modulation degree.

Further, by switching the operation of the transistors forming a current source 58, operational states of transistors Q21, Q22 forming the switching circuit 67 are switched, whereby the output is increased by about 1 dB in the SECAM mode.

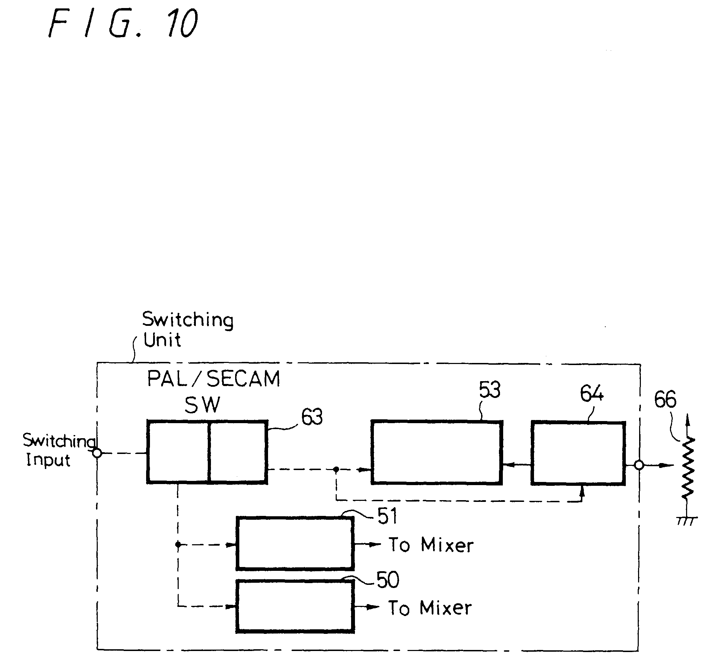

Figure 10 is a schematic block diagram showing an arrangement of the PAL/SECAM switching system in the above embodiment. As shown, operational states of the audio modulators 50, 51, the video modulator 53, the SECAM fine adjusting circuit 64, the RF level switching circuit 67 and the like can be switched by a DC switch of a simple arrangement which can be fabricated into the IC 40, to simplify the otherwise very complex circuit arrangement.

In this RF modulator, the SECAM audio signal $S_{SECAM}$ and the PAL audio signal $S_{PAL}$, respectively mounted by the SECAM mixer circuit- 52 and the PAL mixer circuit 53, and the video signal $S_U$, are mixed by the adding amplifier 57 and supplied through the output terminal T2 as the RF output signal RFout.

Further, in this embodiment, since the RF processing circuits of two systems are provided, and the RF-processed signals are mixed by the adding amplifier 57, thereby to generate the RF modulator output RFout, the occurrence of the intermodulation distortion can be avoided. Thus, it is possible to avoid the occurrence of sound beat in which shift of the audio signal appears as a modulation component even in the complete absence of the video signal.

With this embodiment, since the mixer circuits for generating the RF output signal are formed as double-balance type mixer circuits, and the voltage generating circuit generates the voltage whose value corresponds to the flow of current in the double-balance type mixer circuits, a deviation of the RF level due to different modulation degrees of the PAL and SECAM modes can be automatically compensated for. Accordingly, the adjustment for switching the operation of the PAL and SECAM modes is not needed, and the external adjusting circuit parts coupled to the IC are not needed. Further, since the required characteristics of the mixer circuits are eased, the adjustment of the AM and FM audio modulators can be made unnecessary, whereby the whole of the audio modulators can be fabricated in the IC. Therefore, the RF modulator can be wholly fabricated as the IC and the RF modulator can be formed without the expensive switch. Thus, the RF modulator can be made compact and inexpensive.

**Claims**

1. An RF modulator comprising:

   a SECAM double balance type mixer (52) for generating a SECAM RF output signal by modulating a high frequency signal supplied thereto from an RF carrier generating source (54, 56) with a predetermined signal;
a PAL double balance type mixer (53) for generating a PAL RF output signal by modulating a high frequency signal supplied thereto from the RF carrier generating source (54, 56) with a predetermined signal;
a SECAM audio modulator (50) for amplitude-modulating a SECAM audio signal supplied thereto and supplying an amplitude-modulated SECAM audio signal to said SECAM double balance type mixer (52);
a PAL audio modulator (51) for frequency-modulating a PAL audio signal supplied thereto and supplying a frequency-modulated PAL audio signal to said PAL mixer (53);
an adding amplifier (57) for mixing the RF output signals of the SECAM mixer (52) and the PAL mixer (53); and
a PAL/SECAM switching circuit (63) for controlling operational states of respective circuits in response to a mode switching signal supplied thereto, so that an audio signal is amplitude-modulated and a video signal is positively modulated in the SECAM mode, while the audio signal is frequency-modulated and the video signal is negatively modulated in the PAL mode.

2. A modulator according to claim 1, comprising a video modulation degree fine adjusting circuit (64) for adjusting the video modulation degree of one of the mixers (52, 53).


**Patentansprüche**

1. RF-Modulator aufweisend:

   einen Mixer (52) vom doppelsymmetrischen SECAM-Typ zur Erzeugung eines SECAM-RF-Ausgangssignales durch Modulation eines diesem von einer RF-Trägererzeugungsquelle (54, 56) zugeführten Hochfrequenzsignales mit einem festgelegten Signal;

   einen Mixer (53) vom doppelsymmetrischen PAL-Typ zur Erzeugung eines PAL-RF-Ausgangssignales durch Modulation eines diesem von einer RF-Trägererzeugungsquelle (54, 56) zugeführten Hochfrequenzsignales mit einem festgelegten Signal;

   einen SECAM-Audiomodulator (50) zur Amplitudenmodulation eines diesem zugeführten SECAM-Audiosignales und Lieferung eines amplitudenmodulierten SECAM-Audiosignales an den Mixer (52) vom doppelsymmetrischen SECAM-Typ;

   einen PAL-Audiomodulator (51) zur Frequenzmodulation eines diesem zugeführten PAL-Audiosignales und Lieferung eines frequenzmodulierten PAL-Audiosignales an den PAL-Mixer (53);

   einen Additionsverstärker (57) zur Mischung der RF-Ausgangssignale von dem SECAM-Mixer (52) und dem PAL-Mixer (53); und

   eine PAL/SECAM-Umschalteschaltung (63) zur Steuerung des Betriebszustandes jeweiliger Schaltungen infolge eines diesem zugeführten Modus-Umschaltesignals,so daß im SECAM-Modus ein Audiosignal amplitudenmoduliert und ein Videosignal positiv moduliert wird, während das Audiosignal im PAL-Modus frequenzmoduliert und das Videosignal negativ moduliert wird.

2. Modulator gemäß Anspruch 1,
   aufweisend eine Video-Modulationsgrad-Feineinstellschaltung (64) zur Einstellung des Video-Modulationsgrades eines der Mixer (52, 53).


**Revendications**

1. Modulateur RF comprenant :

   - un mélangeur SECAM (52) du type symétrique double pour générer un signal de sortie RF SECAM en modulant un signal à haute fréquence fourni à ce mélangeur depuis une source (54, 56) générant des porteuses RF, avec un signal prédéterminé ;
   - un mélangeur PAL (53) du type symétrique double pour générer un signal de sortie RF PAL en modulant un signal à haute fréquence fourni à ce mélangeur depuis la source (54, 56) générant des porteuses RF, avec un signal prédéterminé ;
- un modulateur audio SECAM (50) pour moduler en amplitude un signal audio SECAM fourni au modulateur et fournissant un signal audio SECAM modulé en amplitude audit mélangeur SECAM (52) de type symétrique double ;
- un modulateur audio PAL (51) pour moduler en fréquence un signal audio PAL fourni au modulateur et fournissant un signal audio PAL modulé en fréquence audit mélangeur PAL (53) ;
- un amplificateur-additionneur (57) pour mélanger les signaux de sortie RF du mélangeur SECAM (52) et du mélangeur PAL (53) ; et
- un circuit (63) de commutation PAL/SECAM pour commander des états de fonctionnement des circuits respectifs en réponse à un signal de commutation de mode fourni à ce circuit de commutation, de sorte qu'un signal audio est modulé en amplitude et qu'un signal vidéo est modulé positivement en mode SECAM, tandis que le signal audio est modulé en fréquence et que le signal vidéo est modulé négativement en mode PAL.

2. Modulateur selon la revendication 1, comprenant un circuit (64) de réglage de précision du degré de modulation vidéo pour régler le degré de modulation vidéo de l'un des mélangeurs (52, 53).

FIG. 1

EP 0 507 525 B1

EP 0 507 525 B1

# F I G. 2

# $F I G. \ 3$

Output of AM Modulator

# F I G. 4

RF Output
OUT  OUT

QA  QB
Q1  Q2 Q3  Q4
30
Iosc  OSC
IA
QC  QD
Audio Signal SA Q11  Q12  Q13  Q14
Video Signal Sv

# F I G. 5

I4  I3
QA  QB
VA  VB
Q4  Q3
V1  V2
30
Ic  Video
±ib  ±ib
Io(1+X)
Io(1-X)
Q1  Q2
Audio
$\overline{OSC}$  OSC
2Io

# F I G. 6

Output of RF Modulator

# FIG. 7

T2
RF Out

57

52

54

56
RF Carrier

T1

53

55 driver

64

T7

66

SSECAM

T3

62

50

SPAL

T4

51

63

T5

T6

40

Video Signal Sv

Mode Switching Signal SM

EP 0 507 525 B1

13

F I G. 8

SECAM Audio Signal
SECAM Video Modulation Degree Fine Adjusting Terminal
Video Signal
PAL Audio Signal
T3
T7
T5
T4
50
52
57
62
51
65
RL2
RL1
Q22
Q21
68
67
53
69
69
58 58
58
Vcc
GND
RF OUT
T2
PAL/SECAM SW
63
PAL/SECAM Switching Signal S_M

# FIG. 9

Mixer Output

Video Output

Video Signal

Negative Modulation

Positive Modulation

# F I G. 10

Switching Unit

PAL / SECAM SW

63

53    64    66

Switching Input

51

To Mixer

50

To Mixer